(19)

Europäisches
Patentamt
European
Patent Office
Office européen
des brevets

(11) **EP 3 920 070 A1**

(12) **EUROPEAN PATENT APPLICATION**

(43) Date of publication:
**08.12.2021 Bulletin 2021/49**

(21) Application number: **20194498.0**

(22) Date of filing: **04.09.2020**

(51) Int Cl.:
***G06F 30/20*** (2020.01)          *G05B 1/00* (2006.01)
***G05D 1/00*** (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **03.06.2020 GB 202008354**

(71) Applicant: **Five AI Limited**
**Temple Meads, Bristol BS1 6QS (GB)**

(72) Inventors:
• **REDFORD, John**
**Bristol, BS1 6QS (GB)**
• **WHITESIDE, Iain**
**Bristol, BS1 6QS (GB)**

(74) Representative: **Woodhouse, Thomas Duncan**
**Page White & Farrer**
**Bedford House**
**John Street**
**London WC1N 2BF (GB)**

(54)    **TESTING AND SIMULATION IN AUTONOMOUS DRIVING**

(57)    A computer-implemented method of evaluating the performance of a full or partial autonomous vehicle (AV) stack in simulation, the method comprising: applying an optimization algorithm to a numerical performance function defined over a scenario space, wherein the numerical performance function quantifies the extent of success or failure of the AV stack as a numerical score, and the optimization algorithm searches the scenario space for a driving scenario in which the extent of failure of the AV stack is substantially maximized; wherein the optimization algorithm evaluates multiple driving scenarios in the search space over multiple iterations, by running a simulation of each driving scenario in a simulator, in order to provide perception inputs to the AV stack, and thereby generate at least one simulated agent trace and a simulated ego trace reflecting autonomous decisions taken in the AV stack in response to the simulated perception inputs, wherein later iterations of the multiple iterations are guided by the results of previous iterations of the multiple iterations, with the objective of finding the driving scenario for which the extent of failure of the AV stack is maximized.

FIG. 1

EP 3 920 070 A1

## Description

Technical field

The present disclosure relates to the testing of autonomous vehicle stacks through simulation.

Background

There have been major and rapid developments in the field of autonomous vehicles. An autonomous vehicle is a vehicle which is equipped with sensors and control systems which enable it to operate without a human controlling its behaviour. An autonomous vehicle is equipped with sensors which enable it to perceive its physical environment, such sensors including for example cameras, radar and lidar. Autonomous vehicles are equipped with suitably programmed computers which are capable of processing data received from the sensors and making safe and predictable decisions based on the context which has been perceived by the sensors. There are different facets to testing the behaviour of the sensors and control systems aboard a particular autonomous vehicle, or a type of autonomous vehicle.

Sensor processing may be evaluated in real-world physical facilities. Similarly, the control systems for autonomous vehicles may be tested in the physical world, for example by repeatedly driving known test routes, or by driving routes with a human on-board to manage unpredictable or unknown contexts.

Physical world testing will remain an important factor in the testing of autonomous vehicles capability to make safe and predictable decisions. However, physical world testing is expensive and time-consuming. Increasingly there is more reliance placed on testing using simulated environments. Autonomous vehicles need to have the facility to operate in the same wide variety of circumstances that a human driver can operate in. Such circumstances can incorporate a high level of unpredictability.

It is not viable to achieve from physical testing a test of the behaviour of an autonomous vehicle in all possible scenarios that it may encounter in its driving life. Increasing attention is being placed on the creation of simulation environments which can provide such testing in a manner that gives confidence that the test outcomes represent potential real behaviour of an autonomous vehicle.

Simulation environments need to be able to represent real-world factors that may change in the road layout in which it is navigating. This can include weather conditions, road types, road structures, junction types etc. This list is not exhaustive, as there are many factors that may affect the operation of an ego vehicle. A complex AV stack can be highly sensitive to small changes in road layout, environmental conditions, or a particular combination of factors might result in failure in a way that is very hard to predict.

One approach to simulation testing is "scenario fuzzing". For example, a real-world scenario may be recorded in some form that allows it to be re-created in a simulator, but in a configurable manner. The scenario might be chosen on the basis that it led to failure of an AV in the real world (requiring test driver intervention in the real world). Scenario fuzzing is typically based on randomized or manual changes to parameters of the scenario, with the aim of understanding the cause of the failure.

Summary

A core problem addressed herein is that, as AV stacks improve, the percentage of failure cases decreases. One estimation is that, in order to match human drivers in terms of safety, an AV stack should be capable of making and implementing decisions with an error rate no greater than 1 in $10^7$. Verifying performance at this level in simulation requires the stack to be tested in numerous simulated driving scenarios.

The present techniques increase the efficiency with which the most "challenging" driving scenarios can be located and explored. The problem of finding the most challenging scenarios is formulated as an optimization problem where the aim is to find driving scenarios on which an AV stack under testing is most susceptible to failure. To do so, success and failure is quantified numerically (as one or more numerical performance scores), in a way that permits a structured search of a driving scenario space. The aim is to find scenarios that lead to the worst performance scores, i.e. the greatest extent of failure.

A first aspect herein provides a computer-implemented method of evaluating the performance of a full or partial autonomous vehicle (AV) stack in simulation, the method comprising:

applying an optimization algorithm to a numerical performance function defined over a scenario space, wherein the numerical performance function quantifies the extent of success or failure of the AV stack as a numerical score, and the optimization algorithm searches the scenario space for a driving scenario in which the extent of failure of the AV stack, as indicated by the numerical score, is substantially maximized;
wherein the optimization algorithm evaluates multiple driving scenarios in the search space over multiple iterations, by running a simulation of each driving scenario in a simulator, in order to provide perception inputs to the AV stack, and thereby generate at least one simulated agent trace and a simulated ego trace reflecting autonomous decisions taken in the AV stack in response to the simulated perception inputs, wherein later iterations of the multiple iterations are guided by the results of previous iterations of the multiple iterations, with the objective of finding the driving scenario for which the extent of failure is maximized.

In embodiments, the optimization algorithm may be gradient-based, wherein each iteration computes a gradient of the performance function and the later iterations are guided by the gradients computed in the earlier iterations.

The gradient of the performance function may be estimated numerically in each iteration.

Each scenario in the scenario space may be defined by a set of scenario description parameters to be inputted to the simulator, the simulated ego trace dependent on the scenario description parameters and the autonomous decisions taken in the AV stack.

The performance function may be an aggregation of multiple time-dependent numerical performance metrics used to evaluate the performance of the AV stack, the time-dependent numerical performance metrics selected in dependence on environmental information encoded in the description parameters or generated in the simulator.

The numerical performance function is defined over a continuous numerical range.

The numerical performance function may be a discontinuous function over the whole of scenario space, but locally continuous over localized regions of the scenario space, wherein the method comprises checking that each of the multiple scenarios is within a common one of the localized regions.

The numerical performance function may be based on at least one of:

> distance between an ego agent and another agent,
> distance between an ego agent and an environmental element,
> comfort assessed in terms of acceleration along the ego trace, or a first or higher order time derivative of acceleration,
> progress.

Further aspects herein provide a computer system comprising one or more computers programmed or otherwise configured to implement any of the method steps, and a computer program comprising program instructions for programming a computer system to carry out the method steps.

Brief Description of Figures

For a better understanding of the subject matter taught herein, and to show how embodiments of the same may be carried into effect, reference is made to the following figures in which:

> Figure 1 shows a schematic function block diagram of an autonomous vehicle stack;
> Figure 2 shows a schematic block diagram of a testing pipeline;

Figure 3 shows further details of the testing pipeline;
Figure 4 illustrates how the effect of changes to a set of scenario parameters can be quantified in terms of numerical performance metrics in the context of AV testing; and
Figure 5 illustrates one example of an optimization performed over a scenario space, with the objective of finding driving scenarios on which a tested Av stack exhibits the worst quantified performance.

Detailed Description

There is described below a testing pipeline that can be used to test the performance of all or part of an autonomous vehicle (AV) runtime stack. The testing pipeline is highly flexible and can accommodate many forms of AV stack, operating at any level of autonomy. Note, the term autonomous herein encompasses any level of full or partial autonomy, from Level 1 (driver assistance) to Level 5 (complete autonomy).

A typical AV stack includes perception, prediction, planning and control (sub)systems. The term "planning" is used herein to refer to autonomous decision-making capability (such as trajectory planning) whilst "control" is used refer to the generation of control signals for carrying out autonomous decision. The extent to which planning and control are integrated or separable can vary significantly between different stack implementations - in some stacks, these may be so tightly coupled as to be indistinguishable (e.g. such stacks could plan in terms of control signals directly), whereas other stacks may be architected in a way that draws a clear distinction between the two (e.g. with planning in terms of trajectories, and with separate control optimizations to determine how best to execute a planned trajectory at the control signal level). Unless otherwise indicated, the planning and control terminology used herein does not imply any particular coupling or separation of those aspects.

However a stack is "sliced" for the purpose of testing, the idea of simulation-based testing for autonomous vehicles is to run a simulated driving scenario that an ego agent must navigate, often within a static drivable area (e.g. a particular static road layout) but typically in the presence of one or more other dynamic agents such as other vehicles, bicycles, pedestrians, animals etc. (also referred to as actors or external agents). Simulated perception inputs are derived from the simulation, which in turn feed into the stack or sub-stack under testing, where they are processed in exactly the same way as corresponding physical perception inputs would be, so as to drive autonomous decision making within the (sub-)stack. The ego agent is, in turn, caused to carry out those decisions, thereby simulating the behaviours or a physical autonomous vehicle in those circumstances. The simulated perception inputs changes as the scenario progresses, which in turn drives the autonomous decision making within the (sub-) stack being tested. The results can be logged and analysed in relation to safety and/or other performance criteria. Note the term perception input as used herein can encompass "raw" or minimally-processed sensor data (i.e. the inputs to the lowest-level perception components) as well as higher-level outputs (final or intermediate) of the perception system that serve as inputs to other component(s) of the stack (e.g. other perception components and/or prediction/planning).

Slicing refers to the set or subset of stack components subject to testing. This, in turn, dictates the form of simulated perception inputs that need to be provided to the (sub-)stack, and the way in which autonomous decisions.

For example, testing of a full AV stack, including perception, would typically involve the generation of sufficiently realistic simulated sensor inputs (such as photorealistic image data and/or equally realistic simulated lidar/radar data etc.) that, in turn, can be fed to the perception subsystem and processed in exactly the same way as real sensor data. The resulting outputs of the perception system would, in turn, feed the higher-level prediction and planning system, testing the response of those components to the simulated sensor inputs. In place of the physical actor system, an ego vehicle dynamics model could then be used to translate the resulting control signals into realistic motion of an "ego agent" within the simulation, thereby simulating the response of an ego vehicle to the control signal.

By contrast, so-called "planning-level" simulation would essentially bypass the prediction system. A simulator would provide simpler, higher-level simulated perception inputs that can be fed directly to the prediction and planning components, i.e. rather than attempting to simulate the sensor inputs to the perception system, the simulator would instead simulate the outputs of the perception system which are then inputted to the prediction/planning systems directly. As a general rule, the "lower down" the stack is sliced, the more complex the required simulated perception inputs (ranging from full sensor modelling at one extreme to simple simulated fused location/orientation measurements etc. at the other, which can be derived straightforwardly using efficient techniques like ray tracing).

Between those two extremes, there is scope for many different levels of input slicing, e.g. testing only a subset of the perception system, such as "later" perception components, i.e., components such as filters or fusion components which operate on the outputs from lower-level perception components (such as object detectors, bounding box detectors, motion detectors etc.).

In any of the above, for stacks where control is separable from planning, control could also be bypassed (output slicing). For example, if a manoeuvre planner of the stack plans in terms of trajectories that would feed into a control system within the full stack, for the purpose of the simulation, it could simply be assumed that the ego agent follows each planned trajectory exactly, which bypasses the control system and removes the need for more in-depth vehicle dynamics modelling. This may be sufficient for testing certain planning decisions.

The testing pipeline is described in further detail below but first an example AV stack is described in further detail. This solely to provide context to the description of the testing pipeline that follows. As noted, the described testing pipeline is flexible enough to be applied to any AV stack or sub-stack, within any desired testing framework.

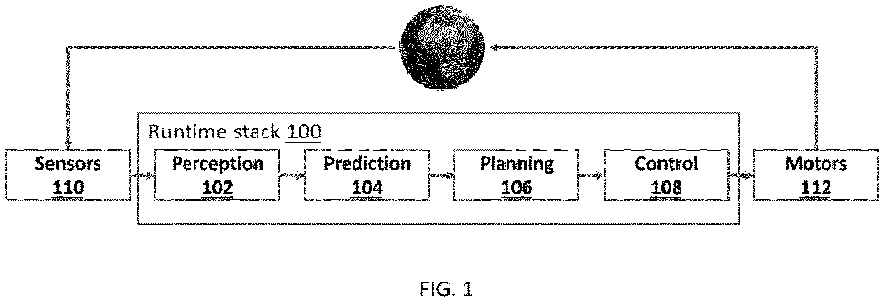

Figure 1 shows a highly schematic block diagram of a runtime stack 100 for an autonomous vehicle (AV), also referred to herein as an ego vehicle (EV). The run time stack 100 is shown to comprise a perception system 102, a prediction system 104, a planner 106 and a controller 108.

In a real-wold context, the perception system 102 would receive sensor outputs from an on-board sensor system 110 of the AV and uses those sensor outputs to detect external agents and measure their physical state, such as their position, velocity, acceleration etc. The on-board sensor system 110 can take different forms but generally comprises a variety of sensors such as image capture devices (cameras/optical sensors), LiDAR and/or RADAR unit(s), satellite-positioning sensor(s) (GPS etc.), motion sensor(s) (accelerometers, gyroscopes etc.) etc., which collectively provide rich sensor data from which it is possible to extract detailed information about the surrounding environment and the state of the AV and any external actors (vehicles, pedestrians, cyclists etc.) within that environment. The sensor outputs typically comprise sensor data of multiple sensor modalities such as stereo images from one or more stereo optical sensors, LiDAR, RADAR etc. Stereo imaging may be used to collect dense depth data, with LiDAR/RADAR etc. proving potentially more accurate but less dense depth data. More generally, depth data collection from multiple sensor modalities may be combined in a way that preferably respects their respective levels of uncertainty (e.g. using Bayesian or non-Bayesian processing or some other statistical process etc.). Multiple stereo pairs of optical sensors may be located around the vehicle e.g. to provide full 360° depth perception.

The perception system 102 comprises multiple perception components which co-operate to interpret the sensor outputs and thereby provide perception outputs to the prediction system 104. External agents may be detected and represented probabilistically in a way that reflects the level of uncertainty in their perception within the perception system 102.

In a simulation context, depending on the nature of the testing - and depending, in particular, on where the stack 100 is sliced - it may or may not be necessary to model the on-board sensor system 100. With higher-level slicing, simulated sensor data is not required therefore complex sensor modelling is not required.

The perception outputs from the perception system 102 are used by the prediction system 104 to predict future behaviour of external actors (agents), such as other vehicles in the vicinity of the AV.

Predictions computed by the prediction system 104 are provided to the planner 106, which uses the predictions to make autonomous driving decisions to be executed by the AV in a given driving scenario. A scenario is represented as a set of scenario description parameters used by the planner 106. A typical scenario would define a drivable area and would also capture predicted movements of any external agents (obstacles, form the AV's perspective) within the drivable area. The driveable area can be determined using perception outputs from the perception system 102 in combination with map information, such as an HD (high-definition) map.

A core function of the planner 106 is the planning of trajectories for the AV (ego trajectories) taking into account predicted agent motion. This may be referred to as maneuver planning. A trajectory is planned in order to carry out a desired goal within a scenario. The goal could for example be to enter a roundabout and leave it at a desired exit; to overtake a vehicle in front; or to stay in a current lane at a target speed (lane following). The goal may, for example, be determined by an autonomous route planner (not shown).

The controller 108 executes the decisions taken by the planner 106 by providing suitable control signals to an on-board actor system 112 of the AV. In particular, the planner 106 plans manoeuvres to be taken by the AV and the controller 108 generates control signals in order to execute those manoeuvres.

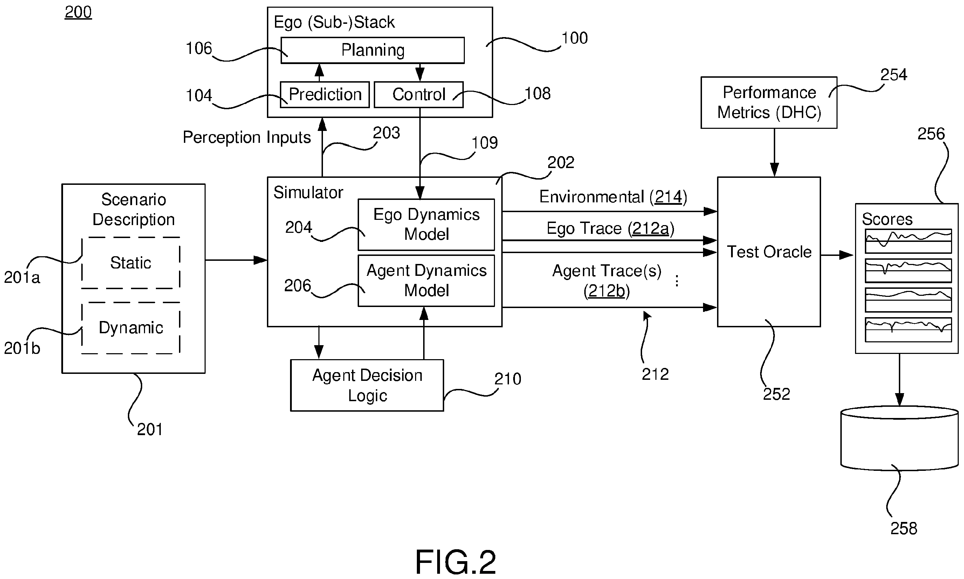

Figure 2 shows a schematic block diagram of a testing pipeline 200. The testing pipeline 200 is shown to comprise a simulator 202 and a test oracle 252. The simulator 202 runs simulations for the purpose of testing all or part of an AV run time stack.

By way of example only, the description of the testing pipeline 200 makes reference to the runtime stack 100 of Figure 1 to illustrate some of the underlying principles by example. As discussed, it may be that only a sub-stack of the run-time stack is tested, but for simplicity, the following description refers to the AV stack 100 throughout; noting that what is actually tested might be only a subset of the AV stack 100 of Figure 1, depending on how it is sliced for testing. In Figure 2, reference numeral 100 can therefore denote a full AV stack or only sub-stack depending on the context.

Figure 2 shows the prediction, planning and control systems 104, 106 and 108 within the AV stack 100 being tested, with simulated perception inputs 203 fed from the simulator 202 to the stack 100. However, this does not necessarily imply that the prediction system 104 operates on those simulated perception inputs 203 directly (though that is one viable slicing, in which case the simulated perception inputs 203 would correspond in form to the final outputs of the perception system 102). For instance, in the example depicted in Figure 2A and described in detail below, the AV stack 100 is sliced such that a subset of late perception components 102B (only) are included in a tested sub-stack 100S, together with the prediction, planning and control components 104, 106 and 108 (in this case, the simulated perception inputs 203 would correspond to the outputs of the remaining, earlier perception components that are not implemented with the stack 100 during testing). Where the full perception system 102 is implemented in the stack being tested (or, at least, where one or more lower-level perception components that operate on raw sensor data are included), then the simulated perception inputs 203 would comprise simulated sensor data.

The simulated persecution inputs 203 are used as a basis for prediction and, ultimately, decision-making by the planner 108. The controller 108, in turn, implements the planner's decisions by outputting control signals 109. In a real-world context, these control signals would drive the physical actor system 112 of AV. The format and content of the control signals generated in testing are the same as they would be in a real-world context. However, within the testing pipeline 200, these control signals 109 instead drive the ego dynamics model 204 to simulate motion of the ego agent within the simulator 202.

To the extent that external agents exhibit autonomous behaviour/decision making within the simulator 202, some form of agent decision logic 210 is implemented to carry out those decisions and drive external agent dynamics within the simulator 202 accordingly. The agent decision logic 210 may be comparable in complexity to the ego stack 100 itself or it may have a more limited decision-making capability. The aim is to provide sufficiently realistic external agent behaviour within the simulator 202 to be able to usefully test the decision-making capabilities of the ego stack 100. In some contexts, this does not require any agent decision making logic 210 at all (open-loop simulation), and in other contexts useful testing can be provided using relatively limited agent logic 210 such as basic adaptive cruise control (ACC). Similar to the ego stack 100, any agent decision logic 210 is driven by outputs from the simulator 202, which in turn are used to derive inputs to the agent dynamics models 206 as a basis for the agent behaviour simulations.

A simulation of a driving scenario is run in accordance with a scenario description 201, having both static and dynamic layers 201a, 201b.

The static layer 201a defines static elements of a scenario, which would typically include a static road layout.

The dynamic layer 201b defines dynamic information about external agents within the scenario, such as other vehicles, pedestrians, bicycles etc. The extent of the dynamic information provided can vary. For example, the dynamic layer 201b may comprise, for each external agent, a spatial path to be followed by the agent together with one or both of motion data and behaviour data associated with the path.

In simple open-loop simulation, an external actor simply follows the spatial path and motion data defined in the dynamic layer that is non-reactive i.e. does not react to the ego agent within the simulation. Such open-loop simulation can be implemented without any agent decision logic 210.

However, in "closed-loop" simulation, the dynamic layer 201b instead defines at least one behaviour to be followed along a static path (such as an ACC behaviour). In this, case the agent decision logic 210 implements that behaviour within the simulation in a reactive manner, i.e. reactive to the ego agent and/or other external agent(s). Motion data may still be associated with the static path but in this case is less prescriptive and may for example serve as a target along the path. For example, with an ACC behaviour, target speeds may be set along the path which the agent will seek to match, but the agent decision logic 110 might be permitted to reduce the speed of the external agent below the target at any point along the path in order to maintain a target headway from a forward vehicle.

The output of the simulator 202 for a given simulation includes an ego trace 212a of the ego agent and one or more agent traces 212b of the one or more external agents (traces 212).

A trace is a complete history of an agent's behaviour within a simulation having both spatial and motion components. For example, a trace may take the form of a spatial path having motion data associated with points along the path such as speed, acceleration, jerk (rate of change of acceleration), snap (rate of change of jerk) etc.

Additional information is also provided to supplement and provide context to the traces 212. Such additional information is referred to as "environmental" data 214 which can have both static components (such as road layout) and dynamic components (such as weather conditions to the extent they vary over the course of the simulation).

To an extent, the environmental data 214 may be "passthrough" in that it is directly defined by the scenario description 201 and is unaffected by the outcome of the simulation. For example, the environmental data 214 may include a static road layout that comes from the scenario description 201 directly. However, typically the environmental data 214 would include at least some elements derived within the simulator 202. This could, for example, include simulated weather data, where the simulator 202 is free to change weather conditions as the simulation progresses. In that case, the weather data may be time-dependent, and that time dependency will be reflected in the environmental data 214.

The test oracle 252 receives the traces 212 and the environmental data 214, and scores those outputs against a set of predefined numerical performance metrics to 254. The performance metrics 254 encode what may be referred to herein as a "Digital Highway Code" (DHC). Some examples of suitable performance metrics are given below.

The scoring is time-based: for each performance metric, the test oracle 252 tracks how the value of that metric (the score) changes over time as the simulation progresses. The test oracle 252 provides an output 256 comprising a score-time plot for each performance metric.

The metrics 256 are informative to an expert and the scores can be used to identify and mitigate performance issues within the tested stack 100.

**Testing metrics:**

The performance metrics 252 can be based on various factors, such as distance, speed etc. In the described system, these can mirror a set of applicable road rules, such as the Highway Code applicable to road users in the United Kingdom. The term "Digital Highway Code" (DHC) may be used in relation to the set of performance metrics 252, however, this is merely a convenient shorthand and does not imply any particular jurisdiction. The DHC can be made up of any set of performance metrics 252 that can assess driving performance numerically. As noted, each metric is numerical and time-dependent. The value of a given metric at a partial time is referred to as a score against that metric at that time.

Relatively simple metrics include those based on vehicle speed or acceleration, jerk etc., distance to another agent (e.g. distance to closest cyclist, distance to closest oncoming vehicle, distance to curb, distance to center line etc.). A comfort metric could score the path in terms of acceleration or a first or higher order time derivative of acceleration (jerk, snap etc.). Another form of metric measures progress to a defined goal, such as reaching a particular roundabout exit. A simple progress metric could simply consider time taken to reach a goal. More sophisticated metrics progress metric quantify concepts such as "missed opportunities", e.g. in a roundabout context, the extent to which an ego vehicle is missing opportunities to join a roundabout.

For each metric, as associated "failure threshold" is defined. An ego agent is said to have failed that metric if its score against that metric drops below that threshold.

Not all of the metrics 252 will necessarily apply to a given scenario. For example, a subset of the metrics 254 may be selected that are applicable to a given scenario. An applicable subset of metrics can be selected by the test oracle 252 in dependence on one or both of the environmental data 214 pertaining to the scenario being considered, and the scenario description 201 used to simulate the scenario. For example, certain metrics may only be applicable to roundabouts or junctions etc., or to certain weather or lighting conditions.

One or both of the metrics 254 and their associated failure thresholds may be adapted to a given scenario. For example, speed-based metrics and/or their associated performance functions may be adapted in dependence on an applicable speed limit but also weather/lighting conditions etc.

**Test orchestration:**

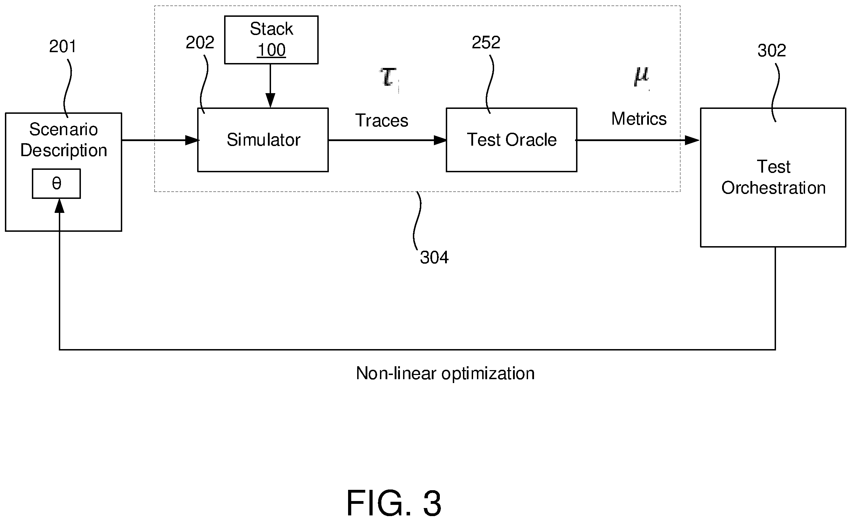

Figure 3 shows further details of the testing pipeline 200. A test orchestration component 302 is shown, which is responsible for setting parameters $\theta$ of a scenario description 201 (scenario parameters or parameters for conciseness) in order to test variations of the scenario it defines. The parameters $\theta$ are defined in a "scenario space", which may have a high dimensionality (i.e. there may be a large number of adjustable scenario parameters $\theta$).

In the field of autonomous driving, the term "fuzzing" is sometimes used to refer to testing of this nature. Thys typically involves some random perturbation of scenario parameters. For example, fuzzing has been used to explore real-world instance of recorded failures (e.g. necessitating test driver intervention), by recreating the scenario, and analysing the effect of slight random perturbations to the scenario parameters.

In the present context, an aim is to move away from "fuzzing" in this sense, to more structured scenario-exploration. In a simulation based on a large scenario space (i.e. with a large number of adjustable scenario parameters), randomized fuzzing is highly inefficient, because of the sheer number of slightly different combinations of parameters that need to be tried.

The test orchestration component 302 leverages the numerical performance metrics 254, with the aim of efficiently determining instances of "maximum failure". That is, finding particular variations of a scenario when the stack performs worst with respect to one or more of the metrics 254. To do so, this problem is formulated as a non-linear optimization; the test orchestration component 203 performs a structured search of the scenario space with the aim of substantially "optimizing" the scenario parameters $\theta$, i.e. finding particular combination of parameter values for which the stack 100 exhibits the *worst* performance with respect to the applicable performance metric(s). The aim is to find variations of a scenario that are most challenging for the stack, in order to efficiently identify performance issues.

As depicted in Figure 3, for a given set of scenario parameters $\theta$ (i.e. a particular combination of values of the scenario parameters $\theta$), the simulator 202 will produce a set of traces $\tau$ (the trace output), which in turn are scored against the set or subset of applicable performance metrics, $\mu$.

For the purpose of tuning the scenario parameters $\theta$, the portion of the pipeline that includes the simulator 202, stack 100 under testing and the test oracle 252 - denoted by reference numeral 304 - is treated as a non-linear function of the scenario parameters $\theta$ (the input), i.e. as a "black box" that takes the scenario parameters $\theta$ and computes the corresponding scores in respect of the applicable performance metric(s) 254. Although not depicted, where applicable, this portion 304 would also include the agent decision logic 210, as this can also affect the traces and hence the scores.

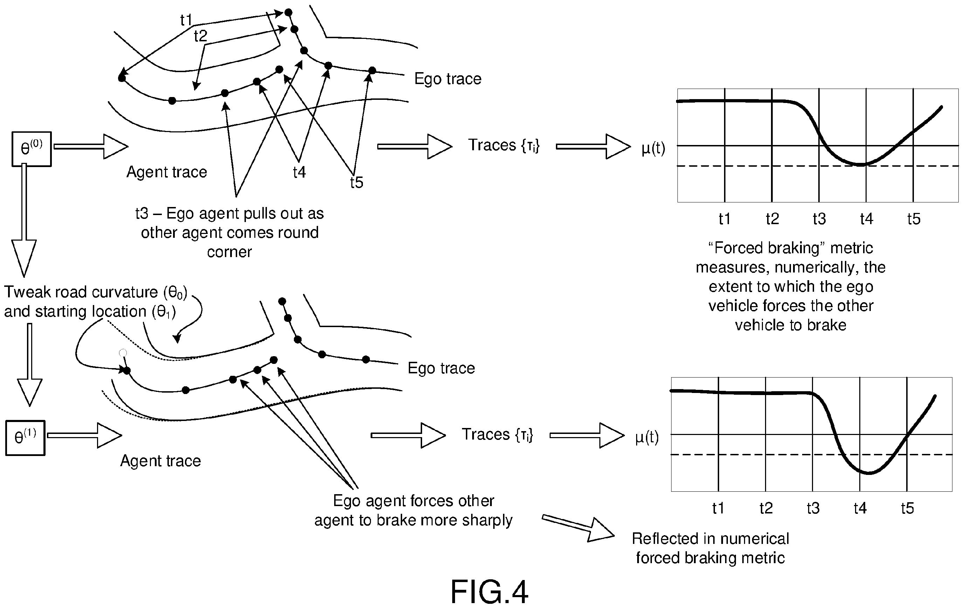

Figure 4 further illustrates the principles of the non-linear optimization by example. This depicts a scenario, in which an ego agent has the goal of joining a major road from a minor road. The major road is curved, in a way that creates a "blind corner" for the ego vehicle, that restricts the visibility of an oncoming vehicle (the other agent). For simplicity, only two parameters are considered: road curvature, $\theta_0$, and starting location of the oncoming vehicle along the road, $\theta_1$. However, the techniques can be applied to a larger number of scenario parameters, including scenarios with hundreds or thousands of adjustable parameters.

A "forced braking" metric is considered in this example. This measures an extent to which the oncoming vehicle is forced to brake by the ego vehicle. This could be implemented, in simulation, by applying a braking behaviour to the other agent, which is implemented in a reactive manner by the agent decision logic 210. To implement the forced braking metric, target motion values could be defined along the other vehicle's path (e.g. speed, acceleration etc.) and the forced braking metric could measure deviation from the target motion values. A certain amount of forced braking may be acceptable; however, the defined failure threshold would represent the point at which the ego vehicle has caused the other vehicle to slow down or brake by an unacceptable amount.

In this simple example, it is reasonable to suppose that both the road curvature $\theta_0$ and the starting location of the oncoming vehicle $\theta_1$ might be relevant to the forced braking metric; Figure 4 depicts two variation of the scenario. In both variations, the stack 100 causes the ego vehicle to pull out in front of the other vehicle, causing it to brake. However, in the second depicted variation, with slightly increased path curvature and with the oncoming vehicle starting slightly further along the road, the oncoming vehicle is forced to brake more aggressively, resulting in worse performance with respect to the forced braking metric.

In this example, an aim of the test orchestration component 302 would be to find substantially "optimal" values of the road curvature and starting location parameters, $\theta_0$ and $\theta_1$, that result in the words performance of the stack 100 with respect to the forced braking metric. "Worst performance" can be quantified in any suitable way, e.g. the aim might be to find the parameters that result in the worst instantaneous score (the global minima of the metric in this example, where a decreasing score indicates worse performance, though this is an arbitrary design choice), or worst averaged score.

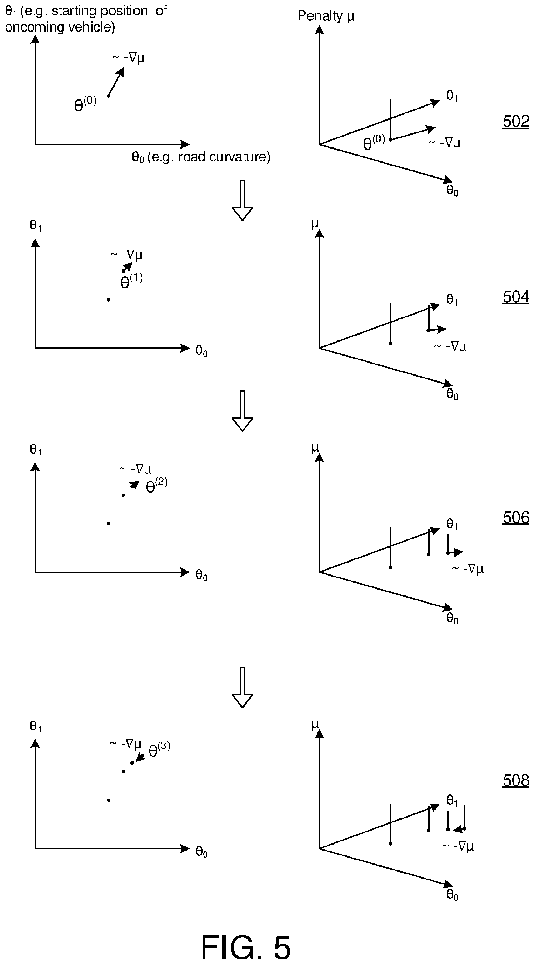

Figure 5 shows one way in which these concepts can be applied within a structured non-linear optimization framework. This example uses gradient-based optimization, such as gradient descent or gradient ascent (depending on how the metrics are defined).

This gradient-based approach systematically explores the search space based on a gradient of the metric with respect to the scenario parameters $\theta$.

The purpose is to test the existing stack 100, by adapting the scenario parameters $\theta$ whilst the parameters of the stack 100 remain fixed (in contrast to, say, end-to-end driving where the purpose is to train a stack end to end, by adjusting parameters of the stack during training with respect to a fixed set of training examples). As noted, the aim is to efficiently find particular combination(s) of the scenario parameters $\theta$ that cause the worst performance of the stack 100 with respect to the metric under consideration.

The example depicted in Figure 5 uses a form of gradient descent. Starting from an initial parameter combination $\theta^{(0)}$ (step 502), which is an initial point in the scenario space, the gradient of a performance function $\mu(\theta)$ is used to guide a search of the scenario space for a point (parameter combination) that is "optimal" in the sense of maximizing the extent of failure on one or more of the defined performance metrics 254.

Superscripts are used to denote a particular iteration (step) of the optimization, whereas subscripts denote individual scenario parameters. Hence, $\theta^{(n)}$ denotes a particular combination of values, $\left(\theta_0^{(n)}, \theta_1^{(n)}\right)$, of the scenario parameters ($\theta_0$, $\theta_1$).

In the above examples, the performance metrics 254 are time-varying functions. The performance function $\mu(\theta)$, which is a time-independent function of the scenario parameters $\theta$ in this example, is derived from one or more of the time-dependent metrics 254, for example as time-average or other aggregation, or at a global minima or maxima. The performance metric $\mu(\theta)$ is derived from a single performance metric in this example, but could be an aggregation of multiple performance metrics 254.

The metric(s) 254 and the performance function $\mu(\theta)$ are numerical and locally continuous, in that small changes in the scenario parameters $\theta$, at least within certain regions of the scenario space, result in substantially continuous changes in $\mu(\theta)$, allowing small changes in the parameters $\theta$ within each such region of the scenario space to be mapped onto continuous changes in the performance function $\mu(\theta)$. In practice, when considered across the whole of the scenario space, the portion of the pipeline 304 depicted in Figure 3 may be a highly non-linear system, in that small changes to the scenario parameters $\theta$ could result in very different agent behaviour (and hence very different performance metrics 254). Taking the example of Figure 4, as the starting location of the other vehicle $\theta_1$ is moved closer and closer to the junction at which the ego agent is located, there may come a point at which the perception of the oncoming vehicle by the ego agent causes the stack 100 to delay pulling out until the oncoming vehicle has passed - as opposed to pulling out in front of the oncoming vehicle, causing it to aggressively brake in response, which might be the response of the stack 100 for a slightly earlier starting location $\theta_1$. This is an example of a highly non-linear response to a small change in the scenario parameter $\theta_1$, which would result in a discontinuous jump in a numerical penalty $\mu(\theta)$ derived from the forced braking metric.

However, prior to that point, the penalty $\mu(\theta)$ might exhibit a substantially continuous response to changes in $\theta_1$; if the stack pulls out because it fails to perceive the oncoming vehicle in time, then the less distance the oncoming vehicle has to brake, the more aggressive the braking it will require to stop in time.

Returning to step 502 of Figure 5, the gradient of the performance function at the initial point in the scenario space, $\nabla\mu(\theta^{(0)})$, is computed or estimated, and a step is taken in the scenario space in proportion to the negative gradient $-\nabla\mu(\theta^{(0)})$, in order to determine a scenario parameter combination $\theta^{(1)}$ for the next iteration. This is repeated for each iteration, until some convergence criteria (or other terminating criteria) are met, with the starting point in scenario space, $\theta^{(n+1)}$ for each iteration $n + 1$ determined based on the gradient of the performance function, $\nabla\mu(\theta^{(n-1)})$, in the previous iteration $n - 1$.

Gradient-descent is well known per se, and is the therefore not described in further detail. However, it is important to note the context in which this methodology is applied. As noted, this is not about training the stack 100. The parameters $\theta$ define the scenario to be simulated. The aim is to vary the simulated scenario in a structured way, in order to find the worst failure cases. In this sense, this is a "falsification" method that aims to expose the stack 100 to the most challenging simulated scenarios more efficiently and systematically than existing scenario fuzzing techniques.

The present techniques do not require the simulator 202 or the stack 100 (or, more precisely, the portion of the pipeline 304 depicted in Figure 3) to be strictly differentiable, or differentiable in any analytical sense. The only requirement is that, within localized regions of the scenario space, the performance function $\mu(\theta)$ is substantially continuous such that a meaningful gradient can be estimated. The gradient can be estimated numerically. In practice this would mean, given a point $\theta(n)$ in the scenario space, running additional simulations, $\theta^{(n)} + \delta$, with different and small perturbations $\delta$ (i.e. slight changes to the scenario parameters), and fitting a gradient to the resulting values of $\mu(\theta^{(n)} + \delta)$. The perturbations $\delta$ should be small enough that the response of the performance function $\mu(\theta)$ remains substantially continuous.

For a performance function that is globally discontinuous (i.e. over the scenario space as a whole), but continuous over localised regions of the scenario space, the search can be modified to include a check at each iteration to confine the search to a single localized region of the scenario space (i.e. over which the performance function remains substantially continuous). This could be implemented as a check in each iteration $n + 1$ as to whether the updated parameters $\theta^{(n+1)}$ are outside of that localized search region, e.g. if the magnitude of difference in the performance function

$$\left| \mu\left(\theta^{(n-1)}\right) - \mu\left(\theta^{(n)}\right) \right|$$

exceeds some threshold, $\theta^{(n+1)}$ could be classed as outside of the localized region of the scenario space under consideration, and different scenario parameters could be attempted instead.

As will be appreciated, gradient descent is just one example of a suitable optimization technique that can be applied to a non-linear system. Other forms of non-linear optimization may be applied in this context, in order to search for scenario parameters that are optimal in the sense of causing the worst performance of the stack 100 under testing.

In some circumstances, it may be appropriate to formulate this as a constrained optimization, in order to restrict the search space to physically feasible scenarios. For example, taking the example of road curvature $\theta_0$, feasibility constraints could be placed on this parameter, to prevent simulations based on unrealistic road curvature.

One approach to simulation records real-world instances of AV failure (e.g., in the most extreme cases, requiring test driver intervention) and re-produces those scenarios in the simulator, but allows the scenario to be modified by varying the scenario parameters $\theta$. The present techniques can be applied to simulations based on real-world scenarios.

Scoring scenarios systematically and numerically also has the benefit of being able to locate failure cases - which, in this context, would be scenarios for which one or more of the failure thresholds is breached - without requiring prior knowledge of which scenarios the stack 100 is likely to fail on. In this context, the present techniques have the benefit of being able to find scenarios on which the stack 100 fails unexpectedly, via systematic exploration of the scenario space.

References herein to components, functions, modules and the like, denote functional components of a computer system which may be implemented at the hardware level in various ways. A computer system comprises one or more computers that may be programmable or non-programmable. A computer comprises one or more processors which carry out the functionality of the aforementioned functional components. A processor can take the form of a general-purpose processor such as a CPU (Central Processing unit) or accelerator (e.g. GPU) etc. or more specialized form of hardware processor such as an FPGA (Field Programmable Gate Array) or ASIC (Application-Specific Integrated Circuit). That is, a processor may be programmable (e.g. an instruction-based general-purpose processor, FPGA etc.) or non-programmable (e.g. an ASIC). Such a computer system may be implemented in an onboard or offboard context.

## Claims

1. A computer-implemented method of evaluating the performance of a full or partial autonomous vehicle (AV) stack in simulation, the method comprising:

   applying an optimization algorithm to a numerical performance function defined over a scenario space, wherein the numerical performance function quantifies the extent of success or failure of the AV stack as a numerical score, and the optimization algorithm searches the scenario space for a driving scenario in which the extent of failure of the AV stack is substantially maximized;
   wherein the optimization algorithm evaluates multiple driving scenarios in the search space over multiple iterations, by running a simulation of each driving scenario in a simulator, in order to provide perception inputs to the AV stack, and thereby generate at least one simulated agent trace and a simulated ego trace reflecting autonomous decisions taken in the AV stack in response to the simulated perception inputs, wherein later iterations of the multiple iterations are guided by the results of previous iterations of the multiple iterations, with the objective of finding the driving scenario for which the extent of failure of the AV stack is maximized.

2. The method of claim 1, wherein the optimization algorithm is gradient-based, wherein each iteration computes a gradient of the performance function and the later iterations are guided by the gradients computed in the earlier iterations.

3. The method of claim 2, wherein the gradient of the performance function is estimated numerically in each iteration.

4. The method of claim 1, 2 or 3, wherein each scenario in the scenario space is defined by a set of scenario description parameters to be inputted to the simulator, the simulated ego trace dependent on the scenario description parameters and the autonomous decisions taken in the AV stack.

5. The method of any preceding claims, wherein the performance function is an aggregation of multiple time-dependent numerical performance metrics used to evaluate the performance of the AV stack, the time-dependent numerical performance metrics selected in dependence on environmental information encoded in the description parameters or generated in the simulator.

6. The method of any preceding claim, wherein the numerical performance function is defined over a continuous numerical range.

7. The method of any preceding claim, wherein the numerical performance function is a discontinuous function over the whole of scenario space, but locally continuous over localized regions of the scenario space, wherein the method comprises checking that each of the multiple scenarios is within a common one of the localized regions.

8. The method of any preceding claim, wherein the numerical performance function is based on at least one of:

   distance between an ego agent and another agent,
   distance between an ego agent and an environmental element,
   comfort assessed in terms of acceleration along the ego trace, or a first or higher order time derivative of acceleration,
   progress.

9. A computer system comprising one or more computers programmed or otherwise configured to implement the method of any preceding claims.

10. A computer program comprising program instructions for programming a computer system to carry out the method of any of claims 1 to 9.

FIG. 1

FIG.2

FIG. 3

t1
t2

Ego trace

θ^(0)

Agent trace

t4
t5

t3 – Ego agent pulls out as
other agent comes round
corner

Traces {τ_i}

μ(t)

t1   t2   t3   t4   t5

"Forced braking" metric
measures, numerically, the
extent to which the ego
vehicle forces the other
vehicle to brake

Tweak road curvature (θ_0)
and starting location (θ_1)

θ^(1)

Ego trace

Agent trace

Ego agent forces other
agent to brake more sharply

Traces {τ_i}

μ(t)

t1   t2   t3   t4   t5

Reflected in numerical
forced braking metric

FIG.4

EP 3 920 070 A1

FIG. 5

Europäisches
Patentamt

European
Patent Office

Office européen
des brevets

# EUROPEAN SEARCH REPORT

Application Number

EP 20 19 4498

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KOREN MARK ET AL: "Adaptive Stress Testing for Autonomous Vehicles", PROCEEDINGS OF THE IEEE INTELLIGENT VEHICLES SYMPOSIUM, 26 June 2018 (2018-06-26), pages 1898-1904, XP033423346, DOI: 10.1109/IVS.2018.8500400 [retrieved on 2018-10-18] * the whole document * * abstract * * equations (1) and (4) * * figures 2,4,4(b) * * page 1898, column 1, paragraph 3 * * page 1898, column 2, paragraph 1 * * page 1898, column 2, paragraph 4 * * page 1899, column 1, paragraph 4 * * page 1899, column 2, paragraph 3 * * page 1900, column 1, paragraph 1 * * page 1900, column 2, paragraph 1 * * page 1901, column 1, paragraph 2 * * page 1901, column 2, paragraph 2 *<br>----- | 1-10 | INV.<br>G06F30/20<br><br>ADD.<br>G05B1/00<br>G05D1/00 |
| A | ALTHOFF MATTHIAS ET AL: "CommonRoad: Composable benchmarks for motion planning on roads", PROCEEDINGS OF THE IEEE INTELLIGENT VEHICLES SYMPOSIUM, 11 June 2017 (2017-06-11), pages 719-726, XP033133833, DOI: 10.1109/IVS.2017.7995802 [retrieved on 2017-07-28] * the whole document * * abstract * * section IV * * page 723, column 1 * * figures 3,5 *<br>-----<br><br>-/-- | 1-10 | TECHNICAL FIELDS SEARCHED (IPC)<br><br>G06F<br>G05B<br>G05D |

The present search report has been drawn up for all claims

| Place of search | Date of completion of the search | Examiner |
|---|---|---|
| Munich | 17 February 2021 | Rungger, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 20 19 4498

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | RIEDMAIER STEFAN ET AL: "Survey on Scenario-Based Safety Assessment of Automated Vehicles", IEEE ACCESS, vol. 8, 8 May 2020 (2020-05-08), pages 87456-87477, XP011789435, DOI: 10.1109/ACCESS.2020.2993730 [retrieved on 2020-05-19] * the whole document * * abstract * * section IV.D * * section VI * * section VI.B * * section VI.D *  ----- | 1-10 | |

TECHNICAL FIELDS
SEARCHED      (IPC)

The present search report has been drawn up for all claims

| Place of search | Date of completion of the search | Examiner |
|---|---|---|
| Munich | 17 February 2021 | Rungger, Matthias |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

page 2 of 2